# EUROPEAN PATENT SPECIFICATION

(11) **EP 2 067 883 B1**
(45) Date of publication and mention of the grant of the patent: **27.01.2016**
(21) Application number: 08020717.8
(22) Date of filing: 28.11.2008
(51) Int. Cl.: C30B 15/10, C30B 29/06

(54) **Method for producing a vitreous silica crucible**
Verfahren zur Herstellung eines glasartigen Quarztiegels
Procédé pour la fabrication d'un creuset en verre de silice

(30) Priority: 30.11.2007 JP 2007310194
(43) Date of publication of application: 10.06.2009
(73) Proprietor: Japan Super Quartz Corporation, Akita-shi Akita-ken (JP)
(72) Inventor: Kishi, Hiroshi, Akita-shi Akita-ken (JP); Kanda, Minoru, Akita-shi Akita-ken (JP)
(74) Representative: Gulde & Partner

(56) References cited:
- EP-A1- 1 020 546
- EP-A1- 1 094 039
- JP-A- 6 191 986
- JP-A- 2001 233 629
- JP-A- 2005 231 986
- JP-A- 2005 320 241
- JP-A- 2007 008 746
- US-A- 5 306 473
- US-A1- 2002 166 341

## Description

### BACKGROUND OF THE INVENTION

### Field of the Invention

The present invention relates to a vitreous silica crucible used to pull up silicon single crystal, and the vitreous silica crucible can control the expansion coefficient of bubbles in the crucible at a high temperature during pulling-up process. More particularly, the present invention relates to a vitreous silica crucible in which the second stage expansion coefficient of the bubbles in the crucible in the second stage of pulling-up process is smaller than the first expansion coefficient of the bubbles in the first stage of pulling-up process, and that can suppress the influence of the expansion of bubbles in the crucible during the pulling-up process to obtain a high single crystallization rate.

Priority is claimed on Japanese Patent Application No. 2007-310194, filed November 30, 2007, the content of which is incorporated herein by reference.

### Description of the Related Art

Silicon single crystal is mainly manufactured by a method of pulling up the silicon single crystal from a silicon melt. In this method, a vitreous silica crucible is filled with polycrystalline silicon as a raw material, a seed crystal is immersed in the silicon melt, and the seed crystal is slowly pulled up to single-crystallize the silicon, thereby producing a silicon single crystal rod.

In the process of pulling-up, brown ring-like crystals of cristbalite called "brown ring" may be formed on the inner surface of the crucible and may be spread to an area of the crucible inner surface contacting with the silicon melt. When bubbles below the brown rings expand, a part of the brown rings peels off from the crucible inner surface and the broken pieces are mixed into the silicon melt, and a portion of the silicon single crystal contacting with the silicon melt is poly-crystallized by the broken pieces, thereby greatly reducing the yield of single crystal.

Accordingly, a vitreous silica crucible with suppressed the generation of brown rings is known. For example, JP-A-2005-231986 discloses a vitreous silica crucible which can reduce the generation of brown rings by restricting the average aluminum concentration and the average OH-group concentration of a transparent glass layer in the inner surface of the crucible to be within a predetermined range. JP-A-2005-320241 discloses a vitreous silica crucible which can suppress vibration of a melt surface lower than an initial melt surface by setting the number of brown rings within a predetermined range from the initial melt surface to be greater than the number of brown rings within a predetermined range from a residual melt surface. These vitreous silica crucibles for suppressing the occurrence of brown rings are known, but it is difficult to satisfactorily suppress the occurrence of brown rings even by the use of the above-mentioned techniques. In addition, when the expansion coefficient of bubbles in the crucible is great, the strength of the crucible is reduced and the crucible is deformed during pulling-up process, thereby causing a decrease in the single crystallization rate.

Further examples of vitreous silica crucible of the prior art and methods of producing the same are described in JP 2001/233629 A, EP 1 094 039 A1 and EP 1 020 546 A1.

### SUMMARY OF THE INVENTION

The present invention is achieved to solve the above-mentioned problems with the occurrence of brown rings in a vitreous silica crucible. The present invention provides a method for producing a vitreous silica crucible as defined in the claims.

The method of the present invention provides a vitreous silica crucible in which a second stage expansion rate of bubbles, which cause the peeling of the brown rings in a pulling-up step, is lowered in comparison with a first stage expansion rate of bubbles before starting pulling up of silicon single crystal. This vitreous silica crucible can suppress expansion of bubbles in the pulling-up step to make it difficult to generate the peeling of brown rings, deterioration in the strength of the crucible is suppressed, and it is possible to enhance the yield of single crystal silicon.

More particularly, the present invention provides a method of producing a vitreous silica crucible having the following configurations.

According to a first aspect of the present invention, there is provided a vitreous silica crucible for pulling up silicon single crystals by a pulling-up process having a first stage and a second stage after the first stage, comprising a transparent inner layer containing inner layer bubbles, and an outer layer containing outer layer bubbles. The second stage expansion coefficient X2 of the inner-layer bubbles during the second stage is set to 1/3 or less of a first stage expansion coefficient X1 of the inner-layer bubbles during the first stage.

According to a second aspect of the present invention, there is provided a vitreous silica crucible for pulling up silicon single crystal, wherein a second stage expansion coefficient Y2 of the outer-layer bubbles during the second stage is set to 1/2 or less of a first stage expansion coefficient Y1 of the outer-layer bubbles during the first stage. The second aspect is combined with the first aspect.

The first stage may comprises a temperature rising step of heating silicon filled in the crucible for 5 to 25 hours from an atmospheric temperature to a pulling-up temperature ranging from 1,400°C to 1,550°C, and a melting step of maintaining the polycrystalline silicon in an inert gas atmosphere in the pulling-up temperature for a predetermined time.

The first stage may comprise a temperature rising step of heating silicon filled in the crucible from an atmospheric temperature to a pulling-up temperature ranging from 1,400°C to 1,550°C, and a melting step of maintaining the polycrystalline-silicon for 20 hours in an inert gas atmosphere in the pulling-up temperature, and the second stage may start after the melting step and may end when 100 hours has passed after the melting step.

The first stage may start from the beginning of heating silicon filled in the crucible and may end when a necking step of forming a necking portion is finished, and the second stage may start from the end of the necking step and may end at the end of the pulling-up process.

The transparent inner layer may have a thickness of 2 mm or less from the inner surface of the crucible, and the outer layer may be the remainder of the crucible excluding the transparent inner layer.

According to the vitreous silica crucible, since the second stage expansion coefficient X2 of the inner-layer bubbles during the second stage is set to 1/3 or less of a first stage expansion coefficient X1 of the inner-layer bubbles during the first stage, the expansion of the inner-layer bubbles mainly occurs in the first stage of the pulling-up process, and the expansion of the bubbles in the second stage of the pulling-up process is suppressed. Accordingly, even if brown rings are produced in the second stage by the generation of crystals of cristbalite (a form of crystalline silica) on the crucible inner surface, it is possible to inhibit inner layer bubbles from expanding under the brown rings, and exfoliation (or peeling off) of a part of the brown rings from the inner surface of the crucible into the molten silicon can be suppressed. Therefore, it is possible to effectively prevent the defects of single crystal silicon to be manufactured, and the yield of single crystal silicon can be improved.

In the vitreous silica crucible according to the second aspect, since the second stage expansion coefficient Y2 of the outer-layer bubbles during the second stage is set to 1/2 or less of the first stage expansion coefficient Y1 of the outer-layer bubbles during the first stage, the expansion of the outer-layer bubbles is suppressed in the second stage. Accordingly, the deterioration in strength of the vitreous silica crucible can be suppressed in the second stage of the pulling-up process, the shape of the crucible can be excellently maintained at a high temperature, and the silicon melt can be stabilized, thereby enhancing the yield of silicon single crystal.

### BRIEF DESCRIPTION OF THE DRAWINGS

FIG. is a front sectional view illustrating a vitreous silica crucible produced according to a method of the present invention.
FIG 2 is a flowchart illustrating a method of pulling up silicon single crystal by the use of the vitreous silica crucible produced according to the method of the present invention.
FIG 3 is a front view illustrating the method of pulling up silicon single crystal by the use of the vitreous silica crucible produced according to the method of the present invention.
FIG 4 is a front view illustrating an apparatus for manufacturing the vitreous silica crucible.

### DESCRIPTION OF EXEMPLARY EMBODIMENTS

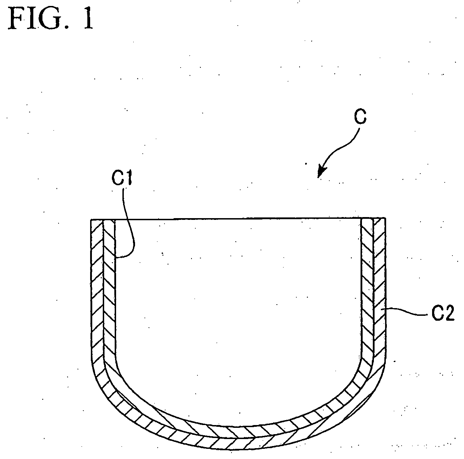

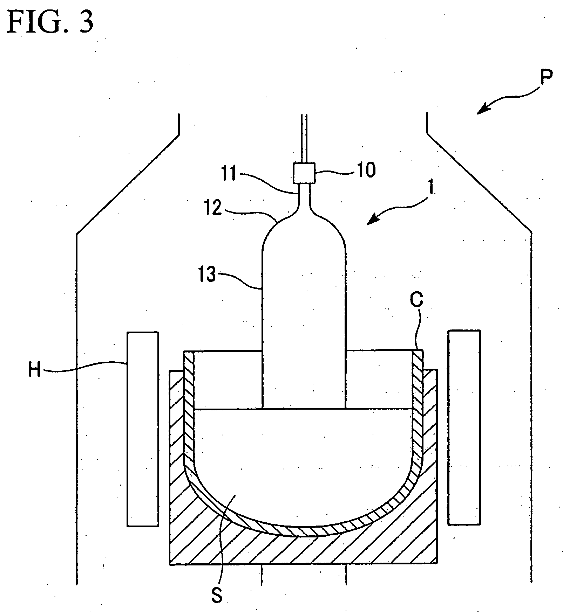

Hereinafter, exemplary embodiments of the present invention will be described in detail with reference to the accompanying drawings. FIG. 1 is a front sectional view illustrating a vitreous silica crucible produced according to a method of the present invention, where reference sign C represents a vitreous silica crucible. The vitreous silica crucible C can be used for pulling up silicon single crystal. As shown in FIGS. 1 and 3, the crucible C consists of an inner-layer portion C1 for contacting with a silicon melt S as a raw material at the time of pulling up the silicon single crystal, and an outer-layer portion C2 which is an outer portion in a thickness direction.

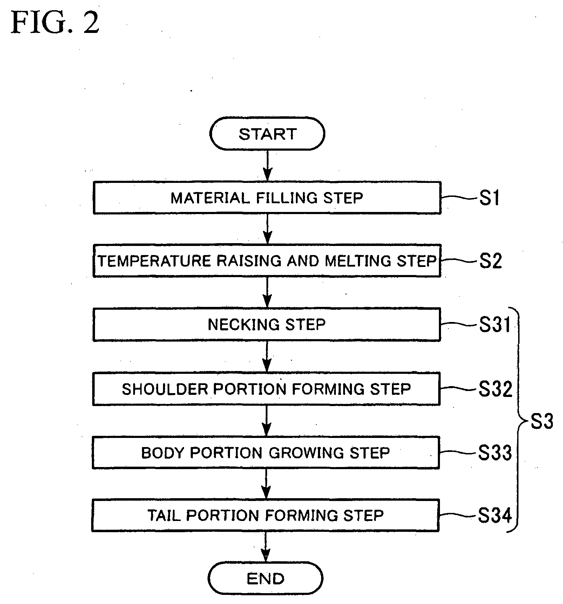

As shown in FIG 2, the pulling-up process of single crystal silicon has a first stage (S2 and S31) and a second stage (S32 and S33) after the first stage.

The inner-layer portion C1 is substantially transparent, and contains very small amount of inner layer bubbles. In this embodiment, the second stage expansion coefficient X2 of the inner-layer bubbles during the second stage (S32 and S33) is set to 1/3 or less of the first stage expansion coefficient X1 of the inner-layer bubbles during the first stage (S2 and S31). The smaller the ratio X2/X1 is, the more the effects of the present invention are improved. However, the ratio X2/X1 may be 1/3 to 1/20, 1/3 to 1/10, 1/3 to 1/5, 1/4 to 1/20, 1/4 to 1/10, or 1/4 to 1/7. The inner-layer portion C1 may be formed of synthetic fused silica or fused quarts (quarts glass).

The outer-layer portion C2 may be translucent or opaque, and contain outer layer bubbles of a predetermined amount which is greater than the amount of the inner layer bubbles in the inner layer portion C1. The second stage expansion coefficient Y2 of the outer-layer bubbles during the second stage (S32 and S33) is set to 1/2 or less of a first stage expansion coefficient Y1 of the outer-layer bubbles during the first stage (S2 and S31). The smaller the ratio Y2/Y1 is, the more the effects of the present invention are improved. However, the ratio Y2/Y1 may be 1/2 to 1/20, 1/2 to 1/10, 1/2 to 1/5, 1/3 to 1/20, 1/3 to 1/10, or 1/3 to 1/6. The outer-layer portion C2 may be formed of fused quarts (quarts glass) or synthetic fused silica. It is possible to form the inner-layer portion C1 and the outer-layer portion C2 using the same fused quarts (quarts glass) or synthetic fused silica; however, it is more preferable to form the inner-layer portion C1 using a synthetic fused silica of a high purity and to form the outer-layer portion C2 using a fused quarts (quarts glass) of a relatively low cost.

FIG. 2 is a flowchart illustrating a method of pulling up silicon single crystal using the vitreous silica crucible according to this embodiment. FIG 3 is a front view illustrating the method of pulling up silicon-single crystal using the vitreous silica crucible according to this embodiment. The pulling-up of silicon single crystal using the vitreous silica crucible C according to this embodiment is performed, for example, by the use of a Czochralski (CZ) method.

As shown in FIG 2, the silicon single crystal pulling-up process includes a material (polycrystalline silicon) filling step S1, a temperature raising and melting step S2, and a pulling-up step S3. The pulling-up step S3 has a necking step S31, a shoulder portion forming step S32, a body portion growing step S33, and a tail portion forming step S34. In this embodiment, the first stage includes of the temperature raising and melting step S2 and the necking step S31. The first stage may include the material filling step S1 because the addition of the material filling step S1 does not provide substantial change in the values of X1 or Y1.

In the material filling step S1, the vitreous silica crucible C is filled with lumps of polycrystalline silicon as a raw material. In the temperature raising and melting step S2, the vitreous silica crucible C filled with the raw material is put into a single crystal pulling-up furnace P shown in FIG 3. The condition in the single crystal pulling-up furnace P is maintained under a melting pressure in the range of 1.33 to 26.66 kPa (10 torr to 200 torr) and in a melting process atmospheric of the inert gas atmosphere, such as an argon gas atmosphere. The crucible C is heated from a room temperature to a pulling-up temperature ranging from 1,400°C to 1,550°C for 5 to 25 hours by a electromagnetic heater H arranged around a susceptor supporting the crucible C as shown in FIG. 3. The crucible C is maintained in the pulling-up temperature range, for example, for 10 hours to melt the lumps of polycrystalline silicon, thereby forming a silicon melt S.

Thereafter, in the pulling-up step S3, under the condition equivalent to the melting process atmospheric condition or a predetermined pulling-up atmospheric condition, seed crystal (silicon single crystal) 10 is immersed in the center of the silicon melt S, the seed crystal 10 is slowly pulled up while rotating the crucible C, silicon single crystal 1 is made to grow using the seed crystal 10 as a nucleus, as shown in FIG. 3. A necking portion 11 is formed in the necking step S31 for excluding dislocations due to thermal impact from the single crystal surface, the diameter of the single crystal is enlarged to form a shoulder portion 12 in the shoulder portion forming step S32, the silicon single crystal 1 having a cylindrical body portion 13 from which silicon wafers are obtained are grown in the body portion growing step S33, and the diameter is reduced and the single crystal is separated from the melt in the tail portion forming step S34.

In the vitreous silica crucible according to this embodiment, the first stage expansion coefficient X of the inner-layer bubbles included in the inner-layer portion C1 under the high temperature condition corresponding to the pulling-up temperature and the melting pressure condition is set so that the expansion coefficient X2 in the second stage (S32 and S33) is 1/3 or less of the expansion coefficient X1 in the first stage (S2 and S31), that is, so that X2/X1≤1/3 is satisfied.

I n addition, the expansion coefficient Y of the outer-layer bubbles included in the outer-layer portion C2 is set so that the expansion coefficient Y2 in the second stage is 1/2 or less of the expansion coefficient Y1 in the first stage, that is, so that Y2/Y1≤1/2 is satisfied.

The pressure condition and the gas atmosphere may be individually set in the melting process and the pulling-up process. In the temperature condition, the temperature in the temperature raising and melting step S2 may be set to be higher than that in the pulling-up step S3. However, regarding the expansion of the bubbles included in the vitreous silica crucible C to be evaluated in this embodiment, the pressure condition and the gas atmosphere are hardly different to be negligible. Accordingly, these are described as the pulling-up condition.

The first stage is a step from the temperature raising and melting step S2 of melting the lump of polycrystalline silicon as a raw material to the necking step S31. The first stage is specifically a step from the start of maintenance under the pulling-up temperature condition to 20 hours thereafter. The second stage is a stage from the end of the necking step S31 to the end of the body portion growing step S33 of the pulling-up step S3, that is, the start of the tail portion forming step S34. The second stage is, for example, a stage from 20 hours after the start of maintenance step under the pulling-up temperature condition to 100 hours after the 20 hours.

Therefore, in the vitreous silica crucible C according to this embodiment, the expansion coefficient X2 from the end of the necking step S31 to the end of the body portion growing step S33 of the pulling-up step S3 is smaller than the expansion coefficient X1 of the inner-layer bubbles included in the inner-layer portion C1 from the temperature raising and melting step S2 to the end of the necking step S31 and is 1/3 or less of X1. Accordingly, the expansion of bubbles in the inner-layer portion C1 of the crucible is made in the first stage and the expansion of bubbles is suppressed in the second stage. As a result, from the end of the first stage, that is, the end of the necking step S31, to the start of the tail portion forming step S34, the brown rings on the surface of the inner-layer portion C1 of the crucible are hardly peeled.

Furthermore, in the vitreous silica crucible according to this embodiment, the expansion coefficient Y2 from the end of the necking step S31 to the end of the body portion growing step S33 of the pulling-up step S3, that is, the start of the tail portion forming step S34, is smaller than the expansion coefficient Y1 of the outer-layer bubbles included in the outer-layer portion C2 from the temperature raising and melting step S2 to the end of the necking step S31 and is 1/2 or less of Y1. Accordingly, since the decrease in strength of the crucible C is small during pulling up the body portion 13 necessary to manufacture silicon wafers and thus the silicon melt is stable, it is possible to enhance the yield of single crystal silicon.

An average expansion coefficient from the start of the maintenance step under the pulling-up temperature condition to 20 hours thereafter can be used as the expansion coefficients X1 and Y1 in the first stage. An average expansion coefficient from 20 hours after the start of maintenance step under the pulling-up temperature condition to 100 hours thereafter can be used as the expansion coefficients X2 and Y2 in the second stage. The bubbles included in the transparent inner layer C1 of the crucible C are bubbles included in a thickness range from the inner surface of the crucible to a thickness of 2 mm by observation with a microscope.

To obtain the expansion coefficient of bubbles, the inner surface of the crucible before use is observed with a microscope and the total area (amount of bubbles) B1 of the bubbles included in a unit area (for example, 1 cm²) of the transparent inner layer is measured. Then, the inner surface of the crucible C in the first stage is observed with a microscope and the total area (corresponding to the amount of bubbles) B2 of the bubbles included in a unit area of the transparent inner layer C1. The expansion coefficients X1 and Y1 in the first stage can be determined (X1, Y1=B2/B1) by the use of the ratio of B2 to B1. Similarly, the inner surface of the crucible in the second stage is observed with a microscope and the total area (amount of bubbles) B3 of the bubbles included in a unit area of the transparent layer is measured. The expansion coefficients X2 and Y2 in the second stage can be determined (X2, Y2=B3/B2) by the use of the ratio of B3 to B2.

The amount of bubbles included in the transparent inner layer C1 of the crucible can be measured by the use of a base pattern matching method. In this method, base patterns based on outline information of bubbles of images observed with a microscope are established in advance and a corresponding base pattern is selected to measure the amount of bubbles from a degree of matching thereof. The bubble outline information includes information such as outline data of the bubbles. The amount of bubbles is measured from the total area of bubbles calculated by the use of the degree of matching (the number corresponding to the base pattern) in consideration of the size of bubbles.

The base pattern matching method is suitable for measuring the bubbles included in the range within 0.3 mm from the inner surface of the crucible (referred to as polar surface). In known measuring methods, bubbles located at a great depth and having a small influence on the surface peeling should be observed, which departs from the focused point and includes sunspots, thereby deteriorating the measurement precision. On the other hand, the base pattern matching method does not have such disadvantages and has an advantage that the amount of bubbles in the polar surface having a great influence on the surface peeling can be measured with high precision. In the base pattern matching method, since the amount of bubbles can be measured using a piece of processing information of the degree of matching, the processing time is short and thus the measurement result can be obtained rapidly.

In general, the bubbles in the crucible expand due to a difference between the gas pressure in the bubbles and the pulling-up atmospheric pressure and the expansion is continued until the contraction due to the surface tension is balanced. In the vitreous silica crucible according to this embodiment, the expansion of bubbles is made in the first stage and the bubbles expand before the brown rings are diffused in the inner surface of the crucible. Accordingly, even when the brown rings generates in the inner surface of the crucible, the expansion of bubbles is small and thus the peeling of the brown rings is hardly made. As a result, the yield of silicon single crystal is enhanced.

Since the tail portion does not influence the single crystallization rate which is the quality of single crystal and the pulling-up time of the tail portion is shorter than the time up to the end of the pulling up the body portion, the expansion coefficients X2 and Y2 in the second stage, that is, from the end of the necking step S31 to the start of the tail portion forming step S34, may be an expansion coefficient from the end of the necking process to the end of the tail portion forming step S34 of the pulling-up step S3.

A method of manufacturing the vitreous silica crucible according to this embodiment will be described now.

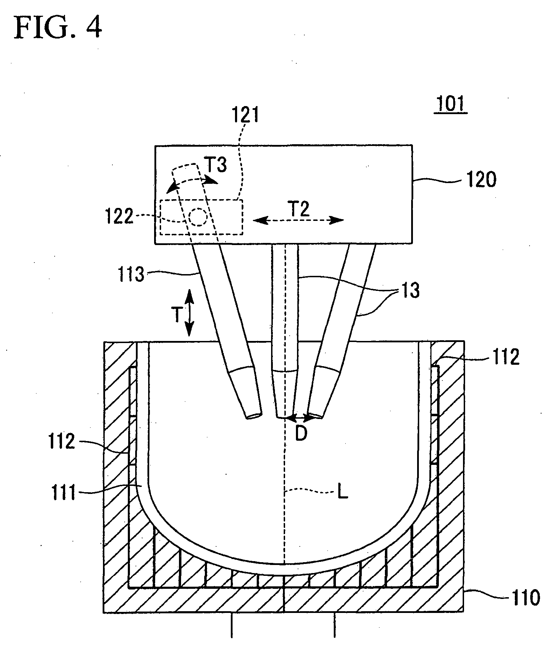

In the method of manufacturing the vitreous silica crucible according to this embodiment, as shown in FIG 4, a crucible manufacturing apparatus 1 having a rotating mold 10 performing a vacuuming operation is used. As shown in FIG. 4, the vitreous silica crucible manufacturing apparatus 101 roughly includes a mold 110 having a melting space for melting quartz powder to form the vitreous silica crucible therein, a driving mechanism rotating the mold 110 in the axis direction, and plural carbon electrodes 113 serving as arc discharge unit heating the inside of the mold 110. The mold 110 is formed of, for example, carbon and has plural depressurizing passages 112 opened on the surface inside the mold 110. A depressurizing mechanism is connected to the depressurizing passages 112 and can suck the gas from the inner surface through the depressurizing passages 112 with the rotation of the mold 110. The inside of the mold 110 can be depressurized or pressurized in an atmospheric pressure by an atmospheric pressure control unit not shown.

Plural electrodes 113 as the arc discharge unit are disposed above the mold 110 in the vitreous silica crucible manufacturing apparatus 101. In the example shown in the drawing, the electrodes 113 are formed by a three-electrode combination. The electrodes 113 are mounted on a supporting member 122 in the upside of the furnace and a mechanism (not shown) vertically moving the electrode 121 is disposed in the supporting member 122. The supporting member 122 includes a supporting portion 121 supporting the carbon electrodes 113 to set an inter-electrode distance D, a horizontal moving mechanism moving the supporting portion 121 in a horizontal direction T2, and a vertical moving mechanism moving the plural supporting portions 121 and the horizontal moving mechanism together in a vertical direction T. The supporting portion 21 includes a rotating mechanism supporting the carbon electrodes 113 to be rotatable about an angle setting axis 122 and controlling a rotation angle of the angle setting axis 122. In order to adjust the set position state of the carbon electrodes 113, the angle direction T3 of the respective carbon electrodes 113 is controlled by the rotating mechanism, the horizontal position of the respective supporting portions 121 is controlled by the horizontal moving mechanism, and the vertical position of the respective supporting portions 121 is controlled by the vertical moving mechanism. The supporting portion 121 and the like are shown in only the left carbon electrode 113 in the drawing, but the other electrodes have the same configuration and the heights of the carbon electrodes 113 can be controlled individually.

After deposition of the quartz powder 111 to form a layer of a substantially uniform thickness, the quartz powder layer 111 is heated, melted, and vitrified by the arc electrodes 113 disposed above the molding space and the mold is vacuumed at the time of melting by the depressurizing mechanism including the depressurizing passages 112 to suck the bubbles in the inner layer, thereby forming a transparent inner layer C1. After the vitrification, the resultant structure is cooled and taken out of the mold to obtain the vitreous silica crucible C.

In the method of manufacturing the vitreous silica crucible according to this embodiment, outer-layer quartz powder is supplied to the inner surface of the rotating mold 110 and is deposited with a predetermined thickness. Inner-layer quartz powder is supplied onto the outer-layer quartz powder 111 and is deposited with a predetermined thickness. As a result, a quartz powder compact 111 is formed. In this case, powder more easily generating micro bubbles at the time of heating the outer-layer powder in comparison with the inner-layer quartz powder is filled, the crucible manufacturing condition including the supply power to the arc electrodes 113, the vertical position and the horizontal position of the arc electrodes 113 and the mold 110, and the depressurized state using the depressurizing mechanism is controlled, and the expansion coefficients X1 and Y1 in the first stage and the expansion coefficients X2 and Y2 in the second stage are determined.

As the crucible manufacturing condition for setting the expansion coefficients to the above-mentioned range, by melting the quartz powder compact 111 up to a predetermined thickness and elongating the heating time of the arc electrodes 113 in a state where the depressurization using the depressurizing passages 112 is not made, it is possible to reduce the bubble density of the inner layer and to control the expansion coefficients as described above. It is preferable that the pressure inside the mold 110 is set to the range of 50 kPa to 200 kPa by the atmospheric pressure control unit not shown. The depressurizing condition using the depressurizing passages 12 is preferably set to the range of 40 kPa to 100 kPa. The power supplied to the arc electrodes is preferably in the output range of 300 kVA to 12,000 kVA. The electrode length consumed per unit time of arc discharge is about 2 mm per minute and the arc melting is made in a state where the center position of the electrode and the rotation center of the mold are matched with each other.

### Examples

Hereinafter, examples of the present invention will be described along with a comparative example.

### Test A

A vitreous silica crucible (with an aperture size of 32 inches) was raised in temperature from the room temperature (20°C) to 1,400°C for 5 hours and was maintained at the temperature for a predetermined time. In the bubbles (inner-layer bubbles) included in the transparent inner layer (up to the depth of 2 mm from the inner surface) of the crucible, the first stage expansion coefficient X1 from the start of maintenance to 20 hours therefrom and the second stage expansion coefficient X2 up to 100 hours after the 20 hours elapsed were measured. The ratios X1/X2 are shown in Table 1. In the bubbles included in the outer-layer portion of the crucible (bubbles included in the range from the depth of 2 mm in the inner surface to the outer surface: the outer-layer bubbles), the expansion coefficient Y1 from the start of maintenance to 20 hours therefrom and the expansion coefficient Y2 up to 100 hours after the 20 hours elapsed were measured. The ratios Y1/Y2 are also shown in Table 1.

**Table 1**

| Sample | Test A | | Test B | | |
|---|---|---|---|---|---|
| | X1/X2 | Y1/Y2 | X1/X2 | Y1/Y2 | Yield of single crystal (%) |
| A1 | 4 | 3 | 4 | 3 | 89 |
| A2 | 4 | 3 | 4 | 1 | 87 |
| A3 | 4 | 3 | 3 | 3 | 86 |
| A4 | 3 | 2 | 4 | 2 | 84 |
| A5 | 3 | 2 | 3 | 2 | 83 |
| B1 | 4 | 3 | 2 | 1 | 56 |
| B2 | 4 | 1 | 2 | 1 | 52 |
| B3 | 1 | 3 | 2 | I | 50 |
| B4 | 2 | 1 | 1 | 1 | 34 |

| | | | | | |
|---|---|---|---|---|---|
| (Note) A 1 to A5 are examples and B1 to B4 are comparative examples. | | | | | |

### Test B

A lump of polycrystalline silicon was put into the same vitreous silica crucible as Test A, the inside of the crucible was maintained in an argon gas atmosphere of 4.0 kPa (30 torr), the temperature was raised from the room temperature (20°C) to 1,400°C for 3 hours, and the temperature was maintained for a predetermined time to melt the lump of silicon, thereby forming a silicon melt. A seed crystal was immersed in the silicon melt (necking process) and was slowly pulled up with the rotation of the crucible, thereby growing silicon single crystal. In the bubbles (inner-layer bubbles) included in the transparent inner layer (up to the depth of 2 mm from the inner surface) of the crucible, the expansion coefficient X1 from the melting of silicon to the end of the necking process and the expansion coefficient X2 from the end of the necking process to the end of the pulling-up were measured. The ratio X1/X2 was shown in Table 1. In the bubbles included in the outer-layer portion of the crucible (bubbles included in the range from the depth of 2 mm in the inner surface to the outer surface: the outer-layer bubbles), the expansion coefficient Y1 from the melting of silicon to the end of the necking process and the expansion coefficient Y2 from the end of the necking process to the end of the pulling-up were measured. The ratio Y1/Y2 was shown in Table 1. The yields of single crystal were also shown in Table 1.

As shown in Table 1, in the crucibles (examples) of Samples A1 to A5, the bubble expansion coefficients of Test A and the bubble expansion coefficients of Test B are in the scope of the present invention and the yields of single crystal are high. On the other hand, in the crucibles (comparative examples) of Samples B1 to B4, some of the bubble expansion coefficients of Test A and the bubble expansion coefficients of Test B depart from the scope of the present invention and thus the yields of single crystal are low. Here, the yield of silicon single crystal (single crystallization rate) is obtained by the weight of the trunk from which silicon single crystalline wafers having no crystal dislocation can be taken/the total weight of polysilicon put into the crucible. When the single crystallization rate varies by 1%, the resultant wafers vary by about 20 sheets.

## Claims

1. A method for producing a vitreous silica crucible made of a transparent inner layer containing inner layer bubbles and an outer layer containing outer layer bubbles, comprising:
depositing quartz powder on inner surface of a rotating mold,
heating the quartz powder layer to melt and vitrify the quartz powder layer by arc electrodes, and
vacuuming at the time of melting by a depressurizing mechanism including depressurizing passages to suck the bubbles in the inner layer, thereby forming the transparent inner layer,
wherein
the pressure inside the mold is set to a range of 50 kPa to 200 kPa by an atmospheric pressure control,
the depressurizing condition using the depressurizing passages is set to the range of 40 kPa to 100 kPa,
the power supplied to the arc electrodes is in the output range of 300 kVA to 12,000 kVA,
the electrode length consumed per unit time of arc discharge is about 2mm per minute, and
the arc melting is made in a state where the center position of the electrode and the rotation center of the mold are matched with each other,
and wherein the vitreous silica crucible is suitable for pulling up silicon single crystals by a first stage and a second stage after the first stage, wherein
the first stage starts from the beginning of heating silicon filled in the crucible and ends when a necking step of forming a necking portion is finished; and
the second stage starts from the end of the necking step and ends at the end of the pulling-up process;
wherein a second stage expansion coefficient X2 of the inner-layer bubbles during the second stage is set to 1/3 or less of a first stage expansion coefficient X1 of the inner-layer bubbles during the first stage; and a second stage expansion coefficient Y2 of the outer-layer bubbles during the second stage is set to 1/2 or less of a first stage expansion coefficient Y1 of the outer-layer bubbles during the first stage.

2. A method according to claim 1, wherein the first stage comprising:
a temperature rising step of heating silicon filled in the crucible for 5 to 25 hours from an atmospheric temperature to a pulling-up temperature ranging from 1,400°C to 1,550°C; and a melting step of maintaining the polycrystalline silicon in an inert gas atmosphere in the pulling-up temperature for a predetermined time.

3. A method according to one of claims 1 to 2, wherein the first stage comprising:
a temperature rising step of heating silicon filled in the crucible for 5 to 25 hours from an atmospheric temperature to a pulling-up temperature ranging from 1,400°C to 1,550°C; and
a melting step of maintaining the polycrystalline silicon for 20 hours in an inert gas atmosphere in the pulling-up temperature, and
the second stage starts after the melting step and ends when 100 hours has passed after the melting step.

4. A method according to one of claims 1 to 3, wherein the transparent inner layer has a thickness of 2 mm or less from the inner surface of the crucible, and the outer layer is the remainder of the crucible excluding the transparent inner layer.

## Patentansprüche

1. Verfahren zum Herstellen eines Kieselglastiegels, der aus einer durchsichtigen Innenschicht, die Innenschichtblasen enthält, und einer Außenschicht, die Außenschichtblasen enthält, besteht, umfassend folgende Schritte:
Abscheiden von Quarzpulver auf der inneren Oberfläche einer Drehgussform,
Erhitzen der Quarzpulverschicht, um die Quarzpulverschicht durch Lichtbogenelektroden aufzuschmelzen und zu verglasen, und
Absaugen beim Aufschmelzen durch einen Druckablassmechanismus, der Druckablassdurchgänge umfasst, um die Blasen in der Innenschicht abzusaugen, wodurch die durchsichtige Innenschicht gebildet wird,
wobei
der Druck im Innern der Gussform durch eine Luftdruckregelung auf einen Bereich von 50 kPa bis 200 kPa eingestellt wird,
der Druckablasszustand, der die Druckablassdurchgänge verwendet, auf den Bereich von 40 kPa bis 100 kPa eingestellt wird,
die Energie, die den Lichtbogenelektroden zugeführt wird, in dem Ausgangsbereich von 300 kVA bis 12000 kVA liegt,
die Elektrodenlänge, die pro Zeiteinheit der Lichtbogenentladung verbraucht wird, ungefähr 2 mm pro Minute beträgt, und
das Lichtbogenschmelzen in einem Zustand erfolgt, in dem die mittlere Position der Elektrode und der Drehmittelpunkt der Gussform aufeinander abgestimmt sind,
und wobei der Kieselglastiegel geeignet ist, um Silizium-Einkristalle durch eine erste Stufe und eine zweite Stufe nach der ersten Stufe aufzuziehen, wobei
die erste Stufe mit dem Beginnen des Erhitzens von Silizium, das in den Tiegel eingefüllt ist, beginnt und endet, wenn ein Halsbildungsschritt des Bildens eines Halsabschnitts beendet ist; und
die zweite Stufe am Ende des Halsbildungsschritts beginnt und am Ende des Aufziehprozesses endet;
wobei ein Ausdehnungskoeffizient X2 der zweiten Stufe der Innenschichtblasen während der zweiten Stufe auf 1/3 oder weniger als ein Ausdehnungskoeffizient X1 der ersten Stufe der Innenschichtblasen während der ersten Stufe eingestellt wird; und ein Ausdehnungskoeffizient Y2 der zweiten Stufe der Außenschichtblasen während der zweiten Stufe auf 1/2 oder weniger als ein Ausdehnungskoeffizient Y1 der ersten Stufe der Außenschichtblasen während der ersten Stufe eingestellt wird.

2. Verfahren nach Anspruch 1, wobei die erste Stufe Folgendes umfasst:
einen Temperaturerhöhungsschritt des Erhitzens von Silizium, das in den Tiegel eingefüllt ist, von 5 bis 25 Stunden lang von einer Lufttemperatur auf eine Aufziehtemperatur, die von 1400 °C bis 1550 °C reicht; und einen Aufschmelzschritt des Haltens des polykristallinen Siliziums in einer Schutzgasatmosphäre auf der Aufziehtemperatur während einer vorbestimmten Zeit.

3. Verfahren nach einem der Ansprüche 1 bis 2, wobei die erste Stufe Folgendes umfasst:
einen Temperaturerhöhungsschritt des Erhitzens von Silizium, das in den Tiegel eingefüllt ist, von 5 bis 25 Stunden lang von einer Lufttemperatur auf eine Aufziehtemperatur, die von 1400 °C bis 1550 °C reicht; und
einen Schmelzschritt des Haltens des polykristallinen Siliziums 20 Stunden lang in einer Schutzgasatmosphäre auf der Aufziehtemperatur, und
wobei die zweite Stufe nach dem Aufschmelzschritt beginnt und endet, wenn 100 Stunden nach dem Aufschmelzschritt vergangen sind.

4. Verfahren nach einem der Ansprüche 1 bis 3, wobei die durchsichtige Innenschicht eine Dicke von 2 mm oder weniger von der Innenfläche des Tiegels aufweist, und die Außenschicht der Rest des Tiegels mit Ausnahme der durchsichtigen Innenschicht ist.

## Revendications

1. Procédé destiné à la production d'un creuset en verre de silice composé d'une couche intérieure transparente contenant des bulles de couche intérieure et d'une couche extérieure contenant des bulles de couche extérieure, comprenant :
le dépôt de poudre de quartz sur la surface intérieure d'un moule rotatif,
le chauffage de la couche de poudre de quartz pour faire fondre et vitrifier la couche de poudre de quartz par des électrodes à arc, et
la mise sous vide au moment de la fusion par un mécanisme de dépressurisation incluant des passages de dépressurisation pour aspirer les bulles dans la couche intérieure, formant ainsi la couche intérieure transparente,
dans lequel
la pression à l'intérieur du moule est réglée dans une plage de 50 kPa à 200 kPa par une commande de la pression atmosphérique,
l'état de dépressurisation à l'aide des passages de dépressurisation est réglé dans la plage de 40 kPa à 100 kPa,
la puissance fournie aux électrodes à arc est dans la plage de sortie de 300 kVa à 12 000 kVa,
la longueur d'électrode consommée par unité de temps de décharge d'arc est d'environ 2 mm par minute, et
la fusion par arc est effectuée dans une situation dans laquelle la position centrale de l'électrode et le centre de rotation du moule sont adaptés réciproquement,
et dans lequel le creuset en verre de silice est approprié pour tirer des cristaux uniques de silicium par une première étape et par une deuxième étape après la première étape, dans lequel
la première étape commence à partir du début du chauffage du silicium rempli dans le creuset et se termine quand une étape de striction consistant à former une portion de striction est terminée ; et
la deuxième étape commence à partir de la fin de l'étape de striction et se termine à la fin du processus de tirage ;
dans lequel un coefficient d'expansion de deuxième étape X2 des bulles de couche intérieure pendant la deuxième étape est réglé à 1/3 ou moins d'un coefficient d'expansion de première étape X1 des bulles de couche intérieure pendant la première étape ; et un coefficient d'expansion de deuxième étape Y2 des bulles de couche extérieure pendant la deuxième étape est réglé à ½ ou moins d'un coefficient d'expansion de première étape Y1 des bulles de couche extérieure pendant la première étape.

2. Procédé selon la revendication 1, dans lequel la première étape comprend :
une étape de montée de température consistant à chauffer le silicium versé dans le creuset pendant 5 à 25 heures à partir d'une température atmosphérique jusqu'à une température de tirage comprise entre 1 400 °C et 1 550 °C ; et une étape de fusion consistant à maintenir du silicium polycristallin dans une atmosphère de gaz inerte à la température de tirage pendant une durée prédéterminée.

3. Procédé selon l'une des revendications 1 à 2, dans lequel la première étape comprend :
une étape de montée de température consistant à chauffer le silicium versé dans le creuset pendant 5 à 25 heures à partir d'une température atmosphérique jusqu'à une température de tirage comprise entre 1 400 °C et 1 550 °C ; et
une étape de fusion consistant à maintenir du silicium polycristallin pendant 20 heures à une atmosphère de gaz inerte à la température de tirage, et
la deuxième étape commence après l'étape de fusion et se termine quand 100 heures ont passé après l'étape de fusion.

4. Procédé selon l'une des revendications 1 à 3, dans lequel la couche intérieure transparente a une épaisseur de 2 mm ou moins à partir de la surface intérieure du creuset, et la couche extérieure est le reste du creuset à l'exclusion de la couche intérieure transparente.
